# EUROPEAN PATENT APPLICATION

(11) **EP 4 510 181 A1**
(43) Date of publication of application: **19.02.2025**
(21) Application number: 23191321.1
(22) Date of filing: 14.08.2023
(51) Int. Cl.: H01L 23/22, H01L 21/54, H01L 23/24, H01L 23/04, H01L 23/31, H01L 23/053, H01L 25/07, H01L 23/20

(54) **POWER SEMICONDUCTOR MODULE ARRANGEMENT AND METHOD FOR PRODUCING THE SAME**

(71) Applicant: Infineon Technologies AG, 85579 Neubiberg (DE)
(72) Inventor: WIESEMANN, Markus, 33605 Bielefeld (DE); HERZER, Anita, 67655 Kaiserslautern (DE)
(74) Representative: Westphal, Mussgnug & Partner, Patentanwälte mbB

(57) **Abstract**

A power semiconductor module arrangement (100) comprises a substrate (10) arranged in or forming a ground surface of a housing (7), the housing (7) comprising sidewalls, at least one semiconductor body (20) arranged on the substrate (10), a first layer (50) partly filling the housing (7) and completely covering the substrate (10) and the at least one semiconductor body (20) arranged thereon, and a second layer (52) arranged adjacent to the first layer (50), wherein the first layer (50) is a liquid or gel-like layer, the second layer (52) is a solid layer, the first layer (50) is arranged between the substrate (10) and the second layer (52), and the second layer (52) is arranged distant from a top of the housing (7).

## Description

### TECHNICAL FIELD

The instant disclosure relates to a power semiconductor module arrangement and to a method for producing such a power semiconductor module arrangement.

### BACKGROUND

Power semiconductor module arrangements often include at least one substrate. A semiconductor arrangement including a plurality of controllable semiconductor elements (e.g., two or more IGBTs) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. Most power semiconductor module arrangements further include an encapsulant at least partly filling the interior of the housing, thereby covering any components and electrical connections that are arranged on the at least one substrate. The encapsulant is generally configured to electrically insulate areas of different electrical potential within the housing and to protect the components and electrical connections of the power semiconductor module from certain environmental conditions and mechanical damage. During the use of the power semiconductor module arrangement, heat may be generated. This is because in general the regulation of high current densities leads to heat generating effects like Joule heating. In addition to that, at least some controllable semiconductor elements of the power semiconductor module arrangement perform a plurality of switching operations during the operation of the power semiconductor module arrangement. When performing many switching operations within a short period of time, for example, the controllable semiconductor elements generate heat. Heat that is generated during the operation of the power semiconductor module arrangement is mostly dissipated from the controllable semiconductor elements to the substrate and further through an optional base plate to a heat sink. However, the encapsulant which is in direct contact with the controllable semiconductor elements may also get heated and local hot spots may occur. Due to the heat, over time, the material of the encapsulant may become brittle, and interfaces between encapsulant and semiconductor elements, or between encapsulant and substrate metallization may be damaged by thermal degradation. This may lead to a reduction of the insulation property of the encapsulant and, consequently, to a failure of the power semiconductor module arrangement.

There is a need for a power semiconductor module arrangement that reduces or even avoids the drawbacks mentioned above as well as others and for a method which allows to produce power semiconductor module arrangements with an increased performance and reliability.

### SUMMARY

A power semiconductor module arrangement includes a substrate arranged in or forming a ground surface of a housing, the housing including sidewalls and, optionally, a top, at least one semiconductor body arranged on the substrate, a first layer partly filling the housing and completely covering the substrate and the at least one semiconductor body arranged thereon, and a second layer arranged adjacent to the first layer, wherein the first layer is a liquid or gel-like layer, the second layer is a gel-like or solid layer, the first layer is arranged between the substrate and the second layer, and the second layer is arranged distant from a top of the housing.

A method includes filling a first material having a first density in a housing, wherein the housing includes sidewalls and, optionally, a top, and a substrate with at least one semiconductor body arranged thereon is arranged in or forms a ground surface of the housing, filling a second material having a second density in the housing, wherein the first density is higher than the second density, thereby forming a liquid first layer consisting of the first material and a liquid or gel-like pre-layer consisting of the second material, and performing a curing step, thereby curing the second material and forming a gel like or solid second layer, wherein the first layer remains liquid or gel-like during and after the curing step, wherein the first layer partly fills the housing and completely covers the substrate and the at least one semiconductor body arranged thereon, the first layer, due to its higher density, forms between the substrate and the second layer, and the second layer is arranged distant from a top of the housing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of a defective power semiconductor module arrangement.
Figure 3 schematically illustrates a cross-sectional view of a power semiconductor module arrangement according to embodiments of the disclosure.
Figures 4 and 5 schematically illustrate a method for forming a power semiconductor module arrangement according to embodiments of the disclosure.
Figure 6 schematically illustrates a cross-sectional view of another power semiconductor module arrangement according to embodiments of the disclosure.
Figure 7, including Figures 7A - 7C, schematically illustrates a method for forming a power semiconductor module arrangement according to further embodiments of the description.
Figure 8 schematically illustrates a chemical formula of functionalized polydiorganylsilicones for encapsulants in module assembly.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not necessarily require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connectable pads and includes at least one semiconductor element with electrodes.

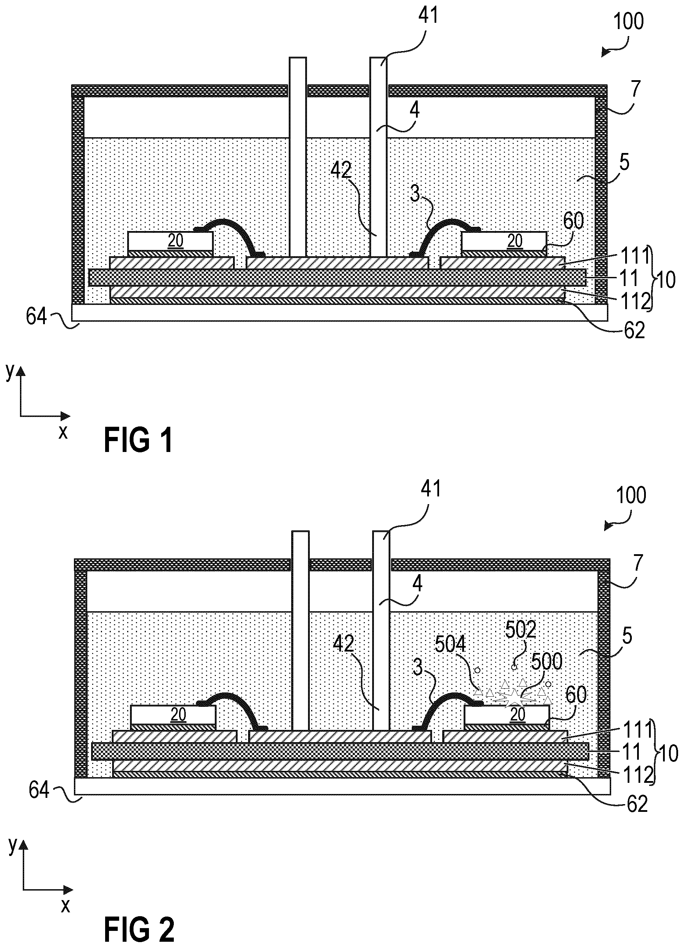

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, SiN or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 64 which forms a base surface of the housing 7, while the housing 7 itself solely comprises sidewalls and a top or cover. In some power semiconductor module arrangements 100, more than one substrate 10 is arranged on the same base plate 64 and within the same housing 7. The base plate 64 may comprise a layer of a metallic material such as, e.g., copper or AlSiC. Other materials, however, are also possible.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example. The one or more substrates 10 may be mechanically and thermally connected to a base plate 64 by means of a connection layer 62. The connection layer 62 may be an electrically insulating adhesive layer, a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41.

Arranging the terminal elements 4 centrally on the substrate 10 is only an example. According to other examples, terminal elements 4 may be arranged closer to or adjacent to the sidewalls of the housing 7. The terminal elements 4 can also be inserted into the housing material, either through manual insertion or by being injection molded into the housing 7. The second end 42 of a terminal element 4 may be electrically and mechanically connected to the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. Alternatively, the terminal elements 4 may also be coupled to the substrate by means of ultrasonic welding.

The power semiconductor module arrangement 100 further includes an encapsulant 5. The encapsulant 5 may consist of or include a cured silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to electrically insulate areas with different electrical potentials (e.g., different sections of the first metallization layer 111) from each other, and to protect the components and electrical connections of the power semiconductor module 100, in particular the components arranged inside the housing 7, from certain environmental conditions and mechanical damage. Silicone materials that are used to form the encapsulant 5 usually can insulate up to 23.000 V/mm. Silicone materials therefore provide far better insulation properties as compared to, e.g., air, which is able to provide electrical insulation up to about 3.000 V/mm.

During the use of the power semiconductor module arrangement 100, the encapsulant 5 may be heated to a certain degree. This is because the high current density of up to 1000 A which is regulated and controlled within the housing, especially in areas with relatively high electrical resistance leads to Joule heating. In addition, at least some semiconductor bodies 20 of the power semiconductor module arrangement 100 generally perform a plurality of switching operations during the operation of the power semiconductor module arrangement 100. When performing many switching operations within a short period of time or by controlling high current densities for a long period of time, for example, the semiconductor bodies 20 generate heat which, in the worst case, may rise to a temperature above a certain maximum threshold. Heat generated during the use of the power semiconductor module arrangement 100 is usually mostly dissipated from the semiconductor bodies 20 to the substrate 10 and further through the base plate 64 to, e.g., a heat sink (not specifically illustrated). However, a certain amount of heat is always also transferred to the encapsulant 5 which directly contacts the semiconductor bodies 20. The encapsulant 5 usually is a cured silicone layer or an epoxy molding compound. When (repeatedly) exposed to heat over a long period of time (e.g., over the expected lifetime of the power semiconductor module arrangement), the encapsulant 5 degrades thermally and may become brittle. In some gel-like materials, liquid ingredients within the loose network may become mobile, which can consequently also lead to a short-time liquification of the encapsulant 5. That is, air filled cracks or bubbles caused by evaporating moisture or partially liquefied encapsulant may form in the encapsulant 5, leading to mechanical instability of the encapsulant 5. Furthermore, partial thermal degradation of interfaces between the encapsulant 5 and the housing 7, between the encapsulant 5 and the semiconductor bodies 20, or between the encapsulant 5 and the substrate 10 may reduce adhesion and consequently result in delaminations. Due to these air-filled cracks, bubbles and delaminations, the encapsulant 5 may then no longer be able to insulate different electrical potentials in this area or protect the components and electrical connections of the power semiconductor module 100 from environmental conditions and mechanical damage.

This process is schematically illustrated in Figure 2 for an encapsulant 5 including a cured silicone gel or a rigid molding compound. Local hot spots 500 may occur in the encapsulant 5 in areas directly adjoining the semiconductor bodies 20. Due to the continuous excessive heat in such hot spot areas 500, areas of delaminated material 504 may start to form in the interface of the encapsulant 5 to the semiconductor element 20, the substrate 10 or the bond wire 3. Delaminated material might also be thermally degraded leading to unspecified and potentially corrosive degradation products 504. In addition, thermoxidative degradation of the silicone results in a hardening of the silicone until ,eventually, the entire encapsulant 5 becomes brittle and mechanically less stable and low volatile degradation products form upon thermal degradation. In combination, the loss of mechanical stability, and formation of degradation products leads to cracks, bubbles and delamations, within or at the interface of the encapsulant 5 to surrounding elements. Typcially, delaminated areas 505 and gas bubbles 502 may also form in the material of the encapsulant 5 due to the heat. Such gas bubbles 502 generally arise in areas close to the semiconductor bodies 20 (hot spot areas 500). As the encapsulant 5 is a cured silicone layer or a rigid molding compound, the gas bubbles 502 as well as the degradation products 504 cannot move to other areas of the encapsulant 5.

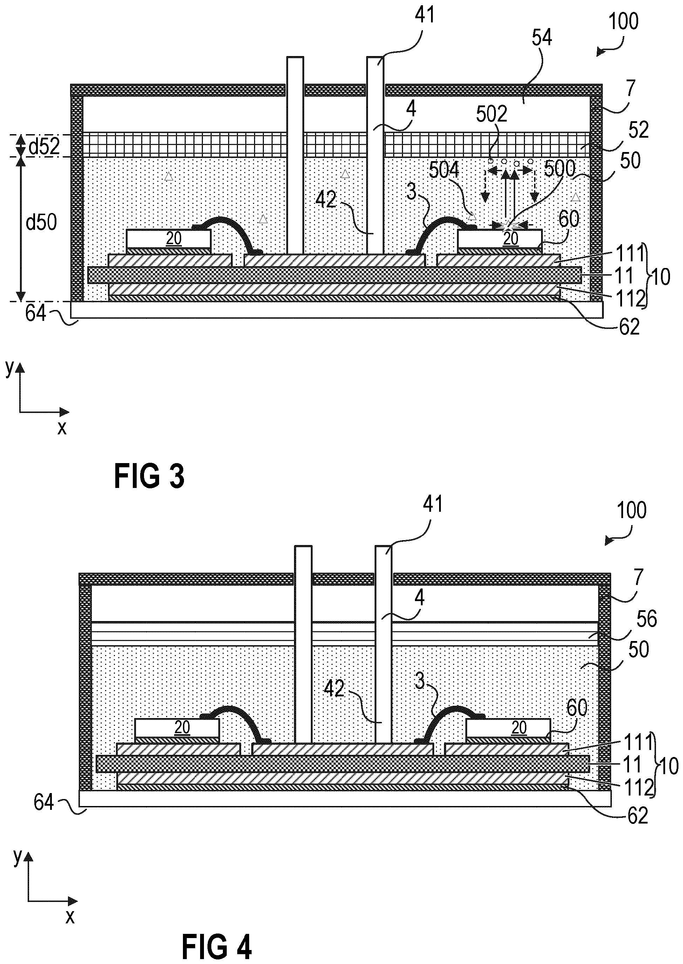

Now referring to Figure 3, a power semiconductor module arrangement 100 according to embodiments of the disclosure is schematically illustrated. The power semiconductor module arrangement 100 generally corresponds to the power semiconductor module arrangement 100 that has been described with respect to Figure 1 above. In the example illustrated in Figure 3, however, the encapsulant comprises two layers, namely a first layer 50 and a second layer 52. The first layer 50 partly fills the housing 7 and completely covers the substrate 10 and the at least one semiconductor body 20 arranged thereon. The second layer 52 is arranged adjacent to the first layer 50 such that the first layer 50 is arranged between the second layer 52 and the substrate 10. The second layer 52 is arranged distant from a top of the housing 7. That is, an area arranged between the first layer 50 and the top of the housing 7 is only partly filled with the material of the second layer 52, and a cavity 54 remains between the second layer 52 and the top of the housing 7. This cavity 54 may be filled with air, for example.

The first layer 50 is a liquid layer. In this way, the local hot spots 500 as have been described with respect to Figure 2 above can be avoided or at least significantly reduced. When a semiconductor body 20 heats during the use of the power semiconductor module arrangement 100, the material of the liquid first layer 50 also heats to a certain degree in those areas directly adjoining the semiconductor body 20. A liquid layer, however, allows convection, as is illustrated by means of the arrows in Figure 3. That is, as the material of the first layer 50 gets heated in the areas close to the semiconductor bodies 20, it rises and carries away the heat from the semiconductor body 20 towards the second layer 52. As the material rises, it cools down again, sinking down again towards the substrate 10. Any heat that is transferred from a semiconductor body 20 to the first layer 50, therefore, is not aggregated in the areas close to the semiconductor bodies 20 such that no, or only insignificant local hot spots 500 occur. The heat is rather distributed to other areas of the first layer 50. Further, any gas bubbles 502 as well as degraded material 504 will not accumulate in the areas close to the semiconductor bodies 20, but will rather be distributed over the entire first layer 50. In addition, a liquid per se does not suffer from delaminated areas, since it always tends to wet the surface of the semiconductor bodies 20 or the substrate 11, and bubbles or delamination are filled with the liquid encapsulant.

A liquid, when heated, expands to a certain degree and contracts when it cools down again. This may be problematic in hermetically sealed housings, as pressure builds up inside the housing when the liquid layer expands. For this reason, the power semiconductor module arrangement 100 illustrated in Figure 3 comprises a second layer 52 arranged above the first layer 50. The second layer 52 is a gel-like or solid layer (e.g., cured (silicone) layer). The second layer 52, however, is flexible to a certain degree. That is, the second layer 52 may be configured to deform when the first layer 50 expands or contracts. The second layer 52 prevents the material of the first layer 50 from flowing out of the housing 7. That is, the second layer 52 seals the lower part of the housing 7 in which the first layer 50 is arranged. The housing 7 may comprise an opening (not specifically illustrated) that is arranged to allow air to flow in or out of the cavity 54 from or to the outside of the housing 7. That is, as the first layer 50 expands, the second layer 52 may deform towards the top of the housing 7. The volume of the cavity 54, therefore, may decrease. In order to prevent pressure from building up inside the housing 7, air may be able to escape from the housing 7 through the opening or gaps since it is not hermetically sealed.

The first layer 50 may have a thickness d50 in the vertical direction y of between 4mm and 20mm (Millimeters), for example. According to one example, a thickness d50 of the first layer 50 is between 5mm and 18mm, e.g., the thickness d50 of the first layer 50 may be 15mm. In this way, there is a sufficient amount of first material to effectively insulate the areas which heat up the most in operating mode, like areas adjacent to semiconductor bodies 20 and electrical connections 3, and carry away heated material from the semiconductor bodies 20. That is, a first layer 50 having a certain thickness d50 allows for adequate convection. The second layer 52 may have a thickness d52 of, e.g., between 3mm and 20mm. According to one example, the thickness d52 of the second layer 52 may be between 5mm and 7mm, e.g., the thickness d52 of the second layer 52 may be 6mm. A second layer 52 having such a thickness d52 is solid enough to prevent the first material from leaking without itself breaking while still being able to flexibly deform when the first layer 50 expands or contracts. If the second layer 52 was too thick, it may no longer be able to deform when the first layer 50 expands or contracts.

The first layer 50 and the second layer 52 may each comprise a (different) silicone material, for example. Typically, silicone insulation encapsulants 5 may be formed by filling liquid silicones into the module which then undergo a hardening, also called curing, reaction under formation of a solid elastomeric network. They usually consist of a basepolymer like polydimethylsiloxanes (PDMS) or polymethyphenylsiloxanes. In order to cure, these basepolymers are typically attached to chemically reactive groups and are combined with chemically reactive networkers in a final mixture. The curing reaction might then be started or accelerated by illuminating the materials with UV-light, heat or activation or addition of a certain catalyst, for example. The platinum catalyzed hydrosilylation reaction of a silane (Si-H) to a vinyl-group represents the most common curing reaction in assembly of power modules. The second layer 52 consists of such a material designated to cure. In contrast, the first layer consists of a basepolymer without chemically reactive groups or additives designated to curing. This, for example, can include a pure PDMS basepolymer or polymethyphenylsiloxanes. It also includes silicone derivatives where other nonreactive chemical groups are attached to the base polymer, e.g. silicones with ethyl- or partially fluorinated alkyl groups. The silicone of the first layer 50 may also contain additives like heat stabilizer or mineralic fillers as long as they do not accelerate or enable curing reactions.

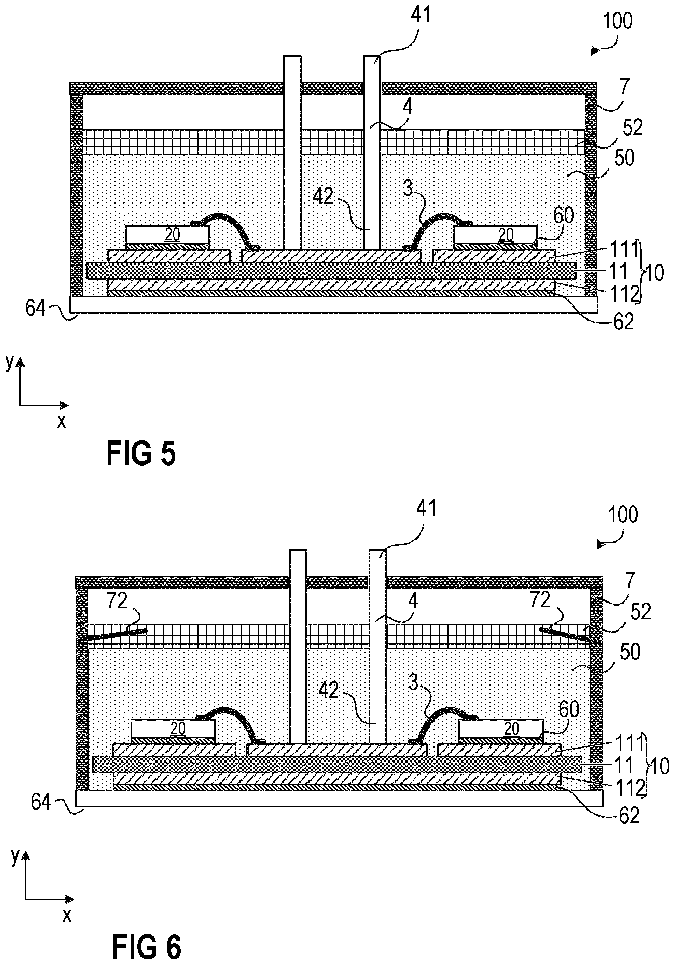

The second layer 52 may have certain adhesive properties and facilitate adhesion to the sidewalls of the housing 7. In this way, it remains in place during the use of the power semiconductor module arrangement 100 and is able to seal against leakage of the first layer 50. According to embodiments of the disclosure, the housing 7 may comprise protrusions 72, extending from the sidewalls of the housing 7 into the second layer 52. The protrusions 72 may be entirely surrounded by the material of the second layer 52. In this way, the mechanical stability of the second layer 52 may be improved while it is still flexible. Additional protrusions increase the surface of the housing and therefore increase the adhesion of the second layer 52 by an extended adhesive surface. With the protrusions 72 extending from the sidewalls of the housing 7 into the second layer 52, the second layer 52 will be securely held in its desired position. The protrusions 72 may be integrally formed with the housing 7, or may be attached to the housing 7 in any suitable way. For example, the protrusions 72 may be glued to the housing 7. The protrusions 72 may have any suitable form. The protrusions 72 may extend in a horizontal direction, or may be beveled with regard to the horizontal direction to a certain degree. The protrusions 72 enlarge the contact area between the housing 7 and the second layer 52. That is, the protrusions 72 provide a high adhesion area. A housing 7 comprising protrusions 72 extending into the second layer 52 is schematically illustrated in Figure 6. The housing 7 may comprise a single protrusion 72, e.g., a protrusion extending circumferentially along the sidewalls of the housing 7. It is, however, also possible that the housing 7 comprises one or more separate protrusions 72 at different positions along the sidewalls of the housing 7.

Now referring to Figures 4 and 5, a method for forming a power semiconductor module arrangement 100 according to embodiments of the disclosure is schematically illustrated. The method comprises filling a first material having a first density in a housing 7, wherein the housing 7 comprises sidewalls and, optionally, a top. A substrate 10 with at least one semiconductor body 20 arranged thereon is arranged in or forms a ground surface of the housing 7. The method further comprises filling a second material having a second density in the housing 7, wherein the first density is higher than the second density, thereby forming a first liquid or gel-like layer 50 consisting of the first material and a liquid or gel-like pre-layer 56 consisting of the second material. According to one example, the density ρ1 of the first material is greater than 0.98 g/cm³ (ρ1> 0.98 g/cm³), and the density ρ2 of the second material is less than 0.98 g/cm³ (ρ 2 < 0.98 g/cm³). A difference between the first density ρ1 and the second density ρ2 may be large enough to ensure a complete separation of the first and second material in order to form the two separate layers. For example, a difference between the first density ρ1 and the second density ρ2 may be at least 0.005 g/cm³, or at least 0.1 g/cm^{3.}

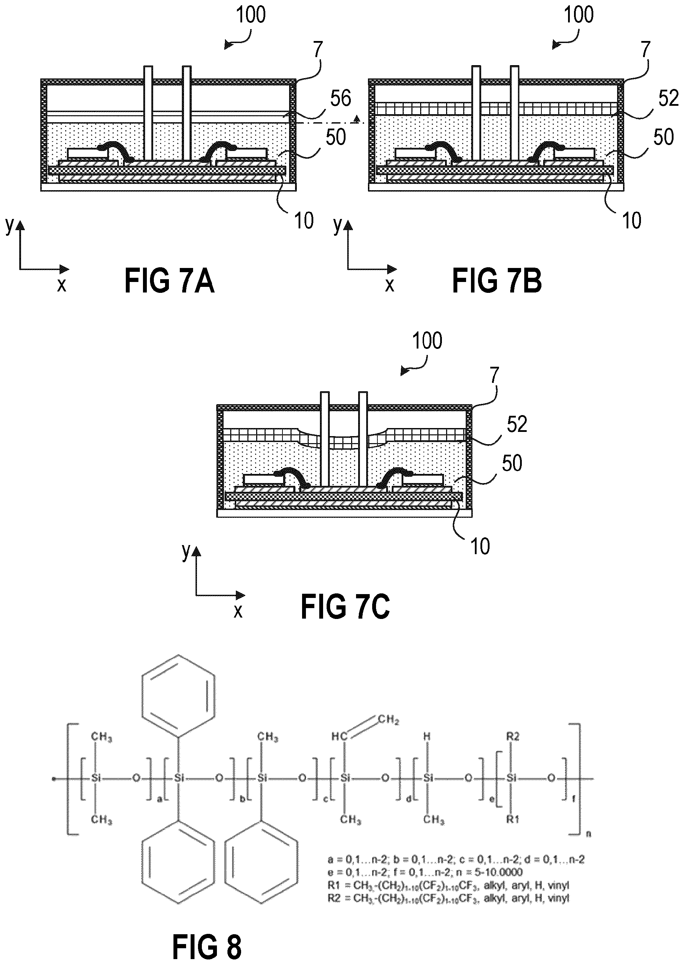

The density of the materials used for the first layer 50 and the second layer 52 may be influenced by the use of different base polymers and fillers or co-solvents which increase or decrease the density. According to an embodiment the following material combinations may be used to have two materials with sufficiently different densities. The first and second material may each comprise a silicone encapsulant. Pure silicone encapsulants typically consist of a base polymer to an amount of >99 vol%. The silicone can also comprise fillers to an amount of >80 vol%. Silicone encapsulants may comprise base polymers bearing methyl, phenyl, vinyl, hydrido and partially fluorinated alkyl side-groups as depicted in Figure 8. The avarage chain length of the polymer n is variable and low molecular silicones with an averaged molecular weight of 200 g/mol and long chain silicone polymers with an averaged molecular weight of 500.000 g/mol and more are commercially available. The density of the silicone base polymer depends on the substitution pattern and the chain length. Short chained vinylated polymethylsiloxanes (PDMS) show, for example, a low density of 0.90 g/cm^{3.} Increasing molecular weight of polymethylsiloxanes also leads to an increase in density up to 0.98 g/cm^{3.} A partial substitution of methyl with phenyl groups leads to silicone base polymers with densities between 0.95 g/cm³ and 1.11 g/cm³ in dependency of the averaged molecular weight. Fluorination of organic substituents allows to further increase the density of the silicone base polymer to 1.22 g/cm³. In addition to these typical properties of a silicone encapsulant material branching of the silicone polymers influences the density as well. A silicone base polymer can also be copolymerized. For example, a copolymerization with polyacrylates leads to UV curable silicone encapsulants. The density of copolymerisats is typically in between the densities of the pure polymers. The given densities of typical silicone base polymers are just examples and more variations of the substitution pattern for higher or lower density might be possible. All given densities are typical values at room temperature. The densities might decrease if elevated temperatures are applied.

According to another embodiment of the disclosure, the first material may comprise or consist of a first base polymer and a second base polymer mixed with a filler and the second material may comprise or consist of a second base polymer. The filler increases a density of the first base polymer to a desired first density ρ1 of the final silicone encapsulant mixture. In general, by adding fillers with densities higher than the silicone base polymer (e.g., SiO₂, TiO₂, Cu, or CaCO₃) the density of the final silicone encapsulant mixture material may be increased.

According to embodiments of the disclosure, the density of the first material and the second material can be influenced by mixing the silicone base polymer with solvents possessing densities lower than 0.90 g/cm3, for example, isopropanol (isopropyl alcohol) with a density of 0.79 g/cm3. According to one example, the second pre-layer 56 may comprise between 10 vol% and 30 vol% of isopropanol, e.g. 20 vol% of isopropanol. Isopropanol, however, generally evaporates during the curing step and is no longer present in the cured second layer 52, as the boiling point of isopropanol is only 82 °C.

According to embodiments of the disclosure, a first layer 50 with a first density ρ1 and a second layer 52 with a second lower density ρ2 are formed inside the housing. The densities of the first and second layer 50, 52 can be selected by their silicone base polymer chain length, the substitution pattern of each silicone base polymer and the amount and density of fillers or by mixing the silicone base polymer with low dense solvents. Every combination of these effects can be used to build the two layers within a module. This includes but is not limited to: 1. A first layer 50 comprising a first silicone base polymer with a high averaged molecular weight and therefore high density ρ1 in combination with a second layer 52 comprising the same silicone base polymer substitution but lower averaged molecular weight and lower density ρ2. 2. A first layer 50 comprising a first silicone base polymer with a variable averaged molecular weight and specific density ρ1 and a second layer 52 with a different silicone base polymer with variable averaged molecular weight and a density ρ2, where the density ρ1 is higher than the density ρ2. 3. A first layer 50 comprising a first silicone base polymer with a variable substitution pattern and a variable averaged molecular weight with a high dense filler with a defined density of the mixture ρ1 and a second layer 52 comprising a second silicone base polymer with a variable substitution pattern and a variable averaged molecular weight without a filler and a defined density of ρ2 where the density ρ1 is higher than the density ρ2. 4. A first layer 50 comprising a first silicone base polymer with a variable substitution pattern and a variable averaged molecular weight with a defined density ρ1 and a second layer 52 comprising a second silicone base polymer with a variable substitution pattern and a variable averaged molecular weight mixed with low dense and volatile solvent with a defined density of the mixture ρ2 where the density ρ1 is higher than the density ρ2. The embodiment is also not limited to silicone base polymers and is also applicable for non-silicone polymers like epoxy mold compound. Therefore, the first layer 50 with a defined density ρ1 or the second layer 52 with a defined density ρ2 may be exchanged with a polymer solution or liquid epoxy mold compound where the density ρ1 is higher than the density ρ2.

The method further comprises performing a curing step, thereby curing the second material and forming a solid or gel-like second layer 52, wherein the first layer 50 remains liquid during and after the curing step. The first layer 50 partly fills the housing 7 and completely covers the substrate 10 and the at least one semiconductor body 20 arranged thereon. The first layer 50, due to its higher density, forms between the substrate 10 and the liquid or gel-like pre-layer 56. The second layer 52 is arranged distant from the top of the housing 7.

The first material and the second material may be filled into the housing 7 simultaneously or successively. The first material and the second material do not mix while being filled into the housing 7. Due to the different densities, the first material will descend and form the first layer 50 adjacent to the substrate 10, while the second material rises and forms the liquid or gel-like pre-layer 56 on top of the first layer 50. This effect occurs automatically without the need for any further supporting measures. To guarantee a separation of both miscible phases, the material of the first and/or the second layer may possess a certain viscosity to reduce diffusion and convection during the filling process and a storage time to the following curing and fixation steps. This may be a viscosity of the first and/or second layer of at least 450 mPa·s or 2000 mPa·s to limit the convection or diffusion to a local interface area of 1mm for 5 min or 10 min etc. This can also include less viscous encapsulant materials which would need a more accurate dispensing process and a fast curing/fixation step. A single curing step may follow. The curing step may comprise heating the power semiconductor module arrangement 100 and/or irradiating the power semiconductor module arrangement 100 with UV-light, for example. It is further possible that a certain amount of pressure is applied during the curing step.

When cured, the second layer 52 adheres to the sidewalls of the housing 7. As has been described above, this adhesion may be sufficient to hold the second layer 52 in its desired position above the first layer 50. If the housing 7 comprises protrusions 72 (see, e.g., Figure 6), the adhesion may be significantly increased. The second layer 52, therefore, seals the area of the housing 7 in which the first layer 50 is arranged and prevents the first material from leaking.

In Figures 4 and 5, all layers are schematically illustrated as flat layers. Figures 4 and 5, however, are only intended to generally describe the underlying principle. Now referring to Figure 7A, a power semiconductor module 100 before performing the curing step is schematically illustrated. As has been described above, the power semiconductor module arrangement 100 may be heated during the curing step. For example, the power semiconductor module arrangement 10 may be heated to temperatures of up to 150°C. When exposed to heat, the first layer 50 expands to a certain degree. This is schematically illustrated in Figure 7B. When the power semiconductor module 100 is subsequently cooled down again, e.g., to room temperature (e.g., 25°C), the first layer 50 contracts. The second layer 52, which was hardened during the curing step, may deform when the power semiconductor module 100 is cooled down. That is, the second layer 52 may be deformed at room temperature, which is schematically illustrated in Figure 7C. The deformation may be reduced when the first layer 50 heats and expands during operation of the power semiconductor module arrangement 100. This expansion of the flexible solid or gel-like second layer 52 allows a thermal expansion of the first liquid layer 50 during operation of the module. In contrast to a hermetically sealed housing, the expansion of the flexible second layer 52 prevents the formation of high pressure within the module which typically reduces module lifetime.

The described method can be performed in only few steps and is therefore very cost effective, as it can be implemented in a fast and easy way. The resulting power semiconductor module arrangement avoids the formation of hot spots in direct vicinity of the semiconductor bodies 20. The first layer 50 does not get brittle over the lifetime of the power semiconductor module arrangement. In this way, the lifetime of the power semiconductor module arrangement can be significantly increased.

## Claims

1. A power semiconductor module arrangement (100) comprising:
a substrate (10) arranged in or forming a ground surface of a housing (7), the housing (7) comprising sidewalls;
at least one semiconductor body (20) arranged on the substrate (10);
a first layer (50) partly filling the housing (7) and completely covering the substrate (10) and the at least one semiconductor body (20) arranged thereon; and
a second layer (52) arranged adjacent to the first layer (50), wherein
the first layer (50) is a liquid or gel-like layer,
the second layer (52) is a solid or gel-like layer,
the first layer (50) is arranged between the substrate (10) and the second layer (52), and
the second layer (52) is arranged distant from a top of the housing (7).

2. The power semiconductor module arrangement of claim 1, wherein the second layer (52) is configured to deform when the first layer (50) expands or contracts during operation of the power semiconductor module arrangement (100).

3. The power semiconductor module arrangement of claim 2, wherein a cavity (54) inside the housing (7) between the second layer (52) and the top of the housing (7) is filled with air, and the housing (7) comprises an opening arranged to allow air to flow between the cavity (54) and the outside of the housing (7).

4. The power semiconductor module arrangement of any of claims 1 to 3, wherein the first layer (50) and the second layer (52) each comprise a silicone material.

5. The power semiconductor module arrangement of claim 4, wherein the second layer (52) is a cured silicone layer.

6. The power semiconductor module arrangement of any of claims 4 or 5, wherein the first layer (50) further comprises a defined amount of a heat stabilizer.

7. The power semiconductor module arrangement of any of the preceding claims, wherein the housing (7) comprises one or more protrusions (72) attached to one or more sidewalls of the housing (7) and extending from the respective sidewall into the second layer (52).

8. A method comprising:
filling a first material having a first density (ρ1) in a housing (7), wherein the housing (7) comprises sidewalls, and a substrate (10) with at least one semiconductor body (20) arranged thereon is arranged in or forms a ground surface of the housing (7),
filling a second material having a second density (ρ2) in the housing (7), wherein the first density (ρ1) is higher than the second density (ρ2), thereby forming a liquid first layer (50) consisting of the first material and a liquid or gel-like pre-layer (56) consisting of the second material, and
performing a curing step, thereby curing the second material and forming a solid or gel like second layer (52), wherein the first layer (50) remains liquid during and after the curing step, wherein
the first layer (50) partly fills the housing (7) and completely covers the substrate (10) and the at least one semiconductor body (20) arranged thereon,
the first layer (50), due to its higher density (ρ1), forms between the substrate (10) and the second layer (52), and
the second layer (52) is arranged distant from a top of the housing (7).

9. The method of claim 8, wherein
filling a first material having a first density (ρ1) in a housing (7) comprises filling a first silicone material in the housing (7), and
filling a second material having a second density (ρ2) in the housing (7) comprises filling a second silicone material in the housing (7).

10. The method of claim 8 or 9, wherein filling a second material in the housing (7) comprises filling a second material comprising at least one of a networker, a catalyst, and an adhesion promoter in the housing (7).

11. The method of any of claims 8 to 10, wherein filling a first material in the housing (7) comprises filling a first material comprising a defined amount of heat stabilizer in the housing (7).

12. The method of any of claims 8 to 11, wherein the steps of filling the first material in the housing (7) and filling the second material in the housing (7) are performed successively.

13. The method of any of claims 8 to 12, wherein the curing step comprises at least one of:
heating the liquid or gel-like pre-layer (56), and
illuminating the liquid or gel-like pre-layer (56) with UV light.

14. The method of any of claims 8 to 13, wherein the first material has a first viscosity and the second material has a second viscosity, and wherein the first viscosity and/or the second viscosity is greater than a defined viscosity to minimize convection and diffusion at an interface between the liquid first layer (50) and the liquid or gel-like pre-layer (56).

15. The method of claim 15, wherein the first material has a first viscosity of at least 450 mPa·s, or at least 2000 mPa·s, and/or the second material has a second viscosity of at least 450 mPa·s, or at least 2000 mPa·s.

## Amended claims

### Amended claims in accordance with Rule 137(2) EPC.

1. A power semiconductor module arrangement (100) comprising:
a substrate (10) arranged in or forming a ground surface of a housing (7), the housing (7) comprising sidewalls;
at least one semiconductor body (20) arranged on the substrate (10);
a first layer (50) partly filling the housing (7) and completely covering the substrate (10) and the at least one semiconductor body (20) arranged thereon; and
a second layer (52) arranged adjacent to the first layer (50), wherein
the first layer (50) is a liquid layer,
the second layer (52) is a solid or gel-like layer,
the first layer (50) is arranged between the substrate (10) and the second layer (52),
the second layer (52) is arranged distant from a cover of the housing (7), and
the first layer (50) consists of a first material without chemically reactive groups or additives designated to curing.

2. The power semiconductor module arrangement of claim 1, wherein the second layer (52) is configured to deform when the first layer (50) expands or contracts during operation of the power semiconductor module arrangement (100).

3. The power semiconductor module arrangement of claim 2, wherein a cavity (54) inside the housing (7) between the second layer (52) and the cover of the housing (7) is filled with air, and the housing (7) comprises an opening arranged to allow air to flow between the cavity (54) and the outside of the housing (7).

4. The power semiconductor module arrangement of any of claims 1 to 3, wherein the first layer (50) and the second layer (52) each comprise a silicone material.

5. The power semiconductor module arrangement of claim 4, wherein the second layer (52) is a cured silicone layer.

6. The power semiconductor module arrangement of any of claims 4 or 5, wherein the first layer (50) further comprises a defined amount of a heat stabilizer, wherein the defined amount of heat stabilizer is low enough to not accelerate or enable curing reactions.

7. The power semiconductor module arrangement of any of the preceding claims, wherein the housing (7) comprises one or more protrusions (72) attached to one or more sidewalls of the housing (7) and extending from the respective sidewall into the second layer (52).

8. A method comprising:
filling a first material having a first density (ρ1) in a housing (7), wherein the housing (7) comprises sidewalls, and a substrate (10) with at least one semiconductor body (20) arranged thereon is arranged in or forms a ground surface of the housing (7),
filling a second material having a second density (p2) in the housing (7), wherein the first density (ρ1) is higher than the second density (p2), thereby forming a liquid first layer (50) consisting of the first material and a liquid or gel-like pre-layer (56) consisting of the second material, and
performing a curing step, thereby curing the second material and forming a solid or gel like second layer (52), wherein the first layer (50) remains liquid during and after the curing step, wherein
the first layer (50) partly fills the housing (7) and completely covers the substrate (10) and the at least one semiconductor body (20) arranged thereon,
the first layer (50), due to its higher density (ρ1), forms between the substrate (10) and the second layer (52),
the second layer (52) is arranged distant from a cover of the housing (7), and
the first layer consists of the first material without chemically reactive groups or additives designated to curing.

9. The method of claim 8, wherein
filling a first material having a first density (ρ1) in a housing (7) comprises filling a first silicone material in the housing (7), and
filling a second material having a second density (p2) in the housing (7) comprises filling a second silicone material in the housing (7).

10. The method of claim 8 or 9, wherein filling a second material in the housing (7) comprises filling a second material comprising at least one of a chemically reactive networker, a catalyst, and an adhesion promoter in the housing (7), wherein the chemically reactive networker, the catalyst, and the adhesion promoter are configured to start and/or accelerate curing of the second material.

11. The method of any of claims 8 to 10, wherein filling a first material in the housing (7) comprises filling a first material comprising a defined amount of heat stabilizer in the housing (7).

12. The method of any of claims 8 to 11, wherein the steps of filling the first material in the housing (7) and filling the second material in the housing (7) are performed successively.

13. The method of any of claims 8 to 12, wherein the curing step comprises at least one of:
heating the liquid or gel-like pre-layer (56), and
illuminating the liquid or gel-like pre-layer (56) with UV light.

14. The method of any of claims 8 to 13, wherein the first material has a first viscosity of at least 450 mPa·s, or at least 2000 mPa·s, and/or the second material has a second viscosity of at least 450 mPa·s, or at least 2000 mPa·s.
